# EUROPÄISCHE PATENTSCHRIFT

(11) **EP 0 363 775 B1**
(45) Veröffentlichungstag und Bekanntmachung des Hinweises auf die Patenterteilung: **13.09.1995**
(21) Anmeldenummer: 89118228.9
(22) Anmeldetag: 02.10.1989
(51) Int. Cl.: C09B 67/30, G03F 7/095

(54) **Verfahren zum Stabilisieren einer Leukofarbstofflösung und durch Strahlung polymerisierbares, einen Leukofarbstoff enthaltendes Gemisch**
Stabilisation process of a leuco dye solution, and mixture, polymerizable by radiation, containing a leuco dye
Procédé de stabilisation d'une solution de colorant leuco et mélange polymérisable par radiation contenant un dérivé leuco

(30) Priorität: 08.10.1988 DE 3834299
(43) Veröffentlichungstag der Anmeldung: 18.04.1990
(73) Patentinhaber: MORTON INTERNATIONAL, INC., Chicago Illinois 60606-1596 (US)
(72) Erfinder: Frommeld, Hans-Dieter. Dr., D-6200 Wiesbaden (DE); Wiezer, Hartmut, Dr., D-6239 Eppstein (DE)
(74) Vertreter: Weber, Dieter, Dr.

(56) Entgegenhaltungen:
- EP-A- 0 230 941
- EP-A- 0 241 419
- EP-A- 0 308 978
- EP-A- 0 311 926
- DE-A- 3 517 173
- GB-A- 2 198 736

## Beschreibung

Die Erfindung betrifft ein Verfahren zum Stabilisieren der Lösung eines Leukofarbstoffes in einem organischen Lösemittel, die entsprechend stabilisierte Lösung sowie ein durch Strahlung polymerisierbares Gemisch, das ein polymeres Bindemittel, eine polymerisierbare Verbindung, einen durch Strahlung aktivierbaren Polymerisationsinitiator und einen Leukofarbstoff enthält.

Gemische der genannten Zusammensetzung sind bekannt. Der Zusatz an Leukofarbstoff bewirkt, daß das Gemisch nach dem Belichten einen sichtbaren Kontrast zwischen belichteten und unbelichteten Bereichen aufweist, da die Leukofarbstoffe während oder nach der Belichtung zu den entsprechenden Farbstoffen oxydiert werden. Solche Gemische sind z. B. in der DE-A 31 31 448 und der EP-A 230 941 beschrieben.

Diese Gemische haben die Neigung, sich schon bei der Lagerung im Dunklen zu verfärben, da Leukofarbstoffe auch im Dunklen langsam oxydiert werden. Diese Tendenz tritt verstärkt auf, wenn zur Kontrastverstärkung Photooxydationsmittel, z. B. Trihalogenmethylverbindungen, die beim Belichten Halogenradikale abspalten, zugesetzt werden. Es wurden deshalb für derartige photopolymerisierbare Gemische und Materialien eine Reihe von Stabilisatoren empfohlen, z. B. Schwefelverbindungen, Phenole und andere Reduktionsmittel.

In der DE-A 35 34 527 wird als Stabilisator Thiuramdisulfid beschrieben. Es ist ebenso wie Thioharnstoff ein mäßiges Stabilisierungsmittel. Diese Verbindungen haben den weiteren Nachteil, daß sie mit Kupferoberflächen reagieren, was sich in Anlauffarben, Schleierbildung beim Entwickeln und Störungen beim anschließenden Galvanisieren äußert. Außerdem setzen Thiuramdisulfide die Lichtempfindlichkeit herab.

In der US-A 3 042 575 werden als Stabilisatoren Phenole wie Resorcin oder Hydrochinon angegeben. Ihre Wirkung ist aber meist unzureichend.

In der DE-A 29 41 846 wird als reduzierender Stabilisator 2,4-Dihydroxy-benzaldoxim genannt, das eine bessere Stabilisierungswirkung hat. Auch bei Zusatz dieser Verbindung ist die Lagerfähigkeit noch nicht ausreichend. Außerdem wird dadurch die Haftung der Schicht auf Kupfer verschlechtert.

In der DE-A 37 35 088 wird vorgeschlagen, derartige Gemische durch Zusatz einer Epoxyverbindung zu stabilisieren. Dieser Zusatz ist für die Bestandteile der festen photopolymerisierbaren Schicht sehr wirksam und verhindert deren Verfärbung auch bei längerer Lagerung.

Es wurde nun gefunden, daß eine Oxydation des Leukofarbstoffes und dadurch eine Verfärbung eines wie vorstehend stabilisierten Gemisches immer dann noch auftritt, wenn das Gemisch - wie es vor der Beschichtung eines Schichtträgers oft unvermeidlich ist - eine gewisse Zeit als Lösung in einem organischen Lösemittel aufbewahrt wird. Diese Verfärbung der Beschichtungslösung unter Lichtausschluß tritt wiederum dann besonders stark auf, wenn die Lösung eine Halogenmethylverbindung enthält. Diese Verfärbung wird jedoch allgemein bei Leukofarbstofflösungen beobachtet, d.h. auch bei Lösungen, die nur den Leukofarbstoff und keine weiteren gelösten Bestandteile enthalten.

Aufgabe der Erfindung war es, ein Verfahren zum Stabilisieren von Leukofarbstoffen in organischen Lösemitteln gegen Oxydation sowie ein durch Strahlung polymerisierbares Gemisch vorzuschlagen, das neben polymerisierbaren Verbindungen und durch Strahlung aktivierbaren Polymerisationsinitiatoren, insbesondere Verbindungen mit Dihalogenmethylen- oder Trihalogenmethylgruppen, noch Leukofarbstoffe enthält und das sich durch Beschichten aus Lösungen verarbeiten läßt, ohne daß es sich beim Stehen in Lösung wesentlich verfärbt.

Erfindungsgemäß wird ein Verfahren zum Stabilisieren einer Leukofarbstofflösung in einem organischen Lösemittel gegen Oxydation an der Luft vorgeschlagen.

Das erfindungsgemäße Verfahren ist dadurch gekennzeichnet, daß man der Lösung eine Verbindung zusetzt, die mindestens eine 2,2,6,6-Tetraalkyl-piperidin-, eine 2,2-Dialkyl-piperidin-6-spiro-cycloalkan- oder eine Piperidin-2,6-dispiro-cycloalkangruppierung enthält.

Erfindungsgemäß wird ferner eine Lösung eines Leukofarbstoffes in einem organischen Lösemittel vorgeschlagen, die dadurch gekennzeichnet ist, daß sie eine Verbindung mit mindestens einer 2,2,6,6-Tetraalkyl-piperidin-, einer 2,2-Dialkyl-piperidin-6-spiro-cycloalkan- oder einer Piperidin-2,6-dispiro-cycloalkangruppierung enthält.

Erfindungsgemäß wird weiterhin ein durch Strahlung polymerisierbares Gemisch vorgeschlagen, das als wesentliche Bestandteile eine polymerisierbare Verbindung mit mindestens einer endständigen ethylenischen Doppelbindung und einem Siedepunkt bei Normaldruck oberhalb 100 °C, eine Verbindung, die unter Einwirkung von aktinischer Strahlung die Polymerisation der ungesättigten Verbindung einzuleiten vermag, und einen Leukofarbstoff enthält.

Das erfindungsgemäße Gemisch ist dadurch gekennzeichnet, daß es ferner eine Verbindung mit mindestens einer 2,2,6,6-Tetraalkyl-piperidin-, einer 2,2-Dialkyl-piperidin-6-spiro-cycloalkan- oder einer Piperidin-2,6-dispiro-cycloalkangruppierung enthält.

Die erfindungsgemäß als Stabilisatoren eingesetzten Piperidinderivate sind als "Hals "-Produkte bekannt. Geeignete Verbindungen sind z B. in Angewandte Makromolekulare Chemie, Heft 158/159 (1988), Seiten 284-285, in der EP-A 42 554 und den DE-A 2 634 957 und 3 641 014 beschrieben.

Diese Verbindungen enthalten als wesentliches Strukturmerkmal eine Gruppe der Formel 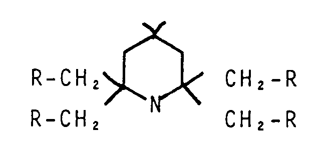
in der alle R untereinander gleich oder verschieden sein können und Wasserstoffatome oder Alkylgruppen mit 1 bis 10 Kohlenstoffatomen bedeuten, wobei jeweils zwei benachbarte Alkylgruppen R zu einem cycloaliphatischen Ring verbunden sein können. Verbindungen mit R=H werden im allgemeinen bevorzugt.

Am Stickstoffatom des Piperidinrings steht ein Wasserstoffatom, eine ggf. substituierte Alkyl- oder Alkylengruppe, die durch Ethersauerstoffatome, Carbonyl-oder Estergruppen unterbrochen sein kann. Wenn eine Alkylengruppe vorliegt, ist sie mit ihrer freien Valenz an eine weitere substituierte Piperidingruppe der oben angegebenen Formel, vorzugsweise in 4-Stellung, gebunden, so daß ggf. polymere Verbindungen entstehen.

In der 4-Stellung kann der Piperidinring einen oder zwei Substituenten tragen, die ggf. untereinander zu einem spiranartig verknüpften iso- oder heterocyclischen Ring verbunden sein können. Vorzugsweise ist ein Substituent in der 4-Stellung über ein Sauerstoff- oder Stickstoffatom an den Ring gebunden. Der Substituent in 4-Stellung kann auch eine Oligomer- oder Polymerkette sein, die zwei oder mehr Piperidinringe trägt.

Wenn die Piperidinverbindung ein Polymeres ist, kann dieses bis zu etwa 30 Piperidingruppierungen im Molekül enthalten.

Die erfindungsgemäßen Lösungen oder Gemische enthalten im allgemeinen 0,1 bis 150, vorzugsweise 2 bis 50 Gew.-% Piperidinderivat, bezogen auf die Menge des Leukofarbstoffes.

Der Zusatz der Piperidinderivate zu Lösungen von Leukofarbstoffen ist in allen Fällen wirksam, in denen Leukofarbstoffe über längere Zeit in Lösung aufbewahrt und vor Oxydation geschützt werden sollen. Die Stabilisierung ist besonders wirksam, wenn die Lösung außerdem lichtempfindliche organische Halogenverbindungen, insbesondere Verbindungen mit Dihalogenmethylen- oder Trihalogenmethylgruppen, wie Dichlormethylen-, Dibrommethylen- oder Tribrommethylgruppen, insbesondere Trichlormethylgruppen, enthält. Das erfindungsgemäße Verfahren der Stabilisierung wird vor allem im Zusammenhang mit photopolymerisierbaren Gemischen angewendet, die als Kontrastgeber Leukofarbstoffe enthalten. Die Gemische enthalten im allgemeinen 0,1 bis 8, bevorzugt 0,3 bis 5 Gew.-%, bezogen auf ihre nichtflüchtigen Bestandteile, an Leukofarbstoff.

Bevorzugte Leukofarbstoffe sind solche der Triphenylmethan- oder Xanthenreihe. Beispiele sind die Leukobasen von Kristallviolett, Victoriablau BH, Victoriareinblau BOH, Methylviolett, Fuchsin, Malachitgrün, Acid Violet 5B, Solar Cyanine 6B, Brilliantgrün und Acilanviolett S. Besonders bevorzugt werden Tris-(p-dimethylamino-phenyl)methan, Tris-(p-diethylaminophenyl)methan, Tris(2-methyl-4-diethylamino-phenyl)methan, Tris-(p-dipropylamino-phenyl)methan und 3,6-Bis-diethylamino-9-phenyl-xanthen.

Neben den Piperidinderivaten können die erfindungsgemäßen photopolymerisierbaren Gemische als zusätzliche Stabilisatoren auch Epoxyverbindungen enthalten, wie es in der DE-A 37 35 088 beschrieben ist.

Die Epoxyverbindungen sollen nicht oder praktisch nicht flüchtig sein. Ihr Molekulargewicht sollte jedoch vorzugsweise nicht größer als 600, insbesondere nicht größer als 400 sein.

Geeignet sind z. B. Glycidylether von aliphatischen und aromatischen Verbindungen, z. B. der Mono- oder Bisglycidylether des 2,2-Bis-(4-hydroxyphenyl)-propans, Phenylglycidylether, tert.-Butylphenylglycidylether, p-Methoxyphenylglycidylether, 2-Ethylhexylglycidylether oder das Styroloxid. Besonders bevorzugt werden Monoepoxide; auch werden Verbindungen mit mindestens einem aromatischen Ring im Molekül, z. B. die Arylglycidylether, bevorzugt. Die Epoxide werden vorzugsweise in Mengen von 0,05 bis 2 Gew.-%, bezogen auf die nichtflüchtigen Bestandteile des Gemisches, zugesetzt.

Als Photoinitiatoren können Benzophenon, Michlers Keton, Thioxanthon, p-Dialkylamino-benzoesäureester, Triarylimidazolyl-dimere und Heterocyclen mit 2 bis 5 aromatischen Ringen und mindestens einem Stickstoffatom als Heteroatom, insbesondere Acridin-, Phenazin- und Chinolinderivate, eingesetzt werden.

Zu nennen sind: 2,2′-Bis-(o-chlorphenyl)-4,4′,5,5′-tetraphenyl-biimidazol, 9-(4′-Tolyl)-acridin, 9-(4′-Methoxyphenyl)-acridin, 9-(4′-Hydroxyphenyl)-acridin, 9-Acetylamino-acridin, 9,10-Dimethyl-benz[a]phenazin, 10-Methyl-benz(a)phenazin, 9-Methoxy-benz[a]phenazin, 10-Methoxy-benz[a]phenazin, Dibenz[a,c]phenazin, 11-Methoxy-dibenz[a,c]phenazin, Dibenz[a,j]phenazin, insbesondere 9-Phenylacridin, 9-(4′-t-Butylphenyl)acridin, Benz[a]phenazin, 9-Methyl-benz[a]phenazin, 2-Styryl-chinolin, Cinnamylidenchinaldin und 3-(o-Chlor-benzyliden)-9-phenyl-2,3-dihydro-1H-cyclopenta[b]chinolin.

Die Menge des Initiators beträgt im allgemeinen 0,01 bis 10, bevorzugt 0,05 bis 4 Gew.-%, bezogen auf die nichtflüchtigen Bestandteile des Gemischs.

Vorzugsweise enthält das Gemisch als Initiator oder als Coinitiator in Kombination mit einer der vorstehend genannten Verbindungen eine Verbindung mit mindestens einem Trihalogenmethylsubstituenten oder einer dihalogenierten Methylengruppe im Molekül.

Von diesen Verbindungen sind insbesondere Tribrommethyl-phenylsulfon, 2,2-Dibrommalonsäurebisamid, α,α-Dibrom-α-cyanomethyl-phenylsulfon, α,α-Dibrom-α-benzoyl-methylphenylsulfon, 2,2-Dibrommalonsäure-bis-N-methylamid, 2,4,6-Tris(trichlormethyl)-s-triazin, 4,6-Bis(trichlormethyl)-s-triazine oder 2-Tribrommethyl-chinolin anzuwenden, wobei von den 4,6-Bis(trichlormethyl)-s-triazinen vorzugsweise die in 2-Stellung substituierten Derivate in Frage kommen. Als Substituenten werden insbesondere Methyl-, Ethyl-, Phenyl-, 4-Methoxyphenyl- oder 4′-Styrylphenyl- eingesetzt. Tribrommethyl-phenylsulfon wird besonders bevorzugt. Der Coinitiator wird vorzugsweise in einer Menge von 0,01 bis 2 Gew.-% eingesetzt.

Für die Zwecke der Erfindung geeignete polymerisierbare Verbindungen sind bekannt und z. B. in den US-A 2 760 863 und 3 060 023 beschrieben.

Bevorzugte Beispiele sind Acryl- und Methacrylsäureester von ein- oder mehrwertigen, bevorzugt mindestens zweiwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben. Der Mengenanteil der Schicht an Monomeren beträgt im allgemeinen etwa 10 bis 80, vorzugsweise 20 bis 60 Gew.-%.

Das Gemisch enthält vorzugsweise noch ein polymeres Bindemittel. Als Bindemittel kann eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: -COOH, -PO₃H₂, -SO₃H; -SO₂NH-, -SO₂-NH-SO₂- und -SO₂-NH-CO-.

Als Beispiele hierfür seien genannt: Maleinatharze, Polymerisate aus N-(p-Tolyl-sulfonyl)-carbaminsäure-ß-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkyl(meth)acrylat/Methacrylsäure-Mischpolymerisate und Mischpolymerisate aus Methacrylsäure, höheren Alkyl(meth)acrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 40 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind:

Haftvermittler, Inhibitoren zur Verhinderung der thermischen Polymerisation der Monomeren, Wasserstoffdonatoren, die Lichtempfindlichkeit derartiger Schichten modifizierende Stoffe, Farbstoffe, gefärbte und ungefärbte Pigmente, Weichmacher, z. B. Polyglykole oder Ester der p-Hydroxybenzoesäure.

Beispiele für geeignete Zusätze sind Schwefelverbindungen, wie Mercaptobenzimidazol, Mercaptobenzthiazol, Imidazol oder Imidazolderivate, Verbindungen mit dreiwertigem Phosphor wie Triphenylphosphin oder Triphenylphosphit.

Diese Bestandteile sind zweckmäßig so auszuwählen, daß sie in dem für den Initiierungsvorgang wichtigen aktinischen Strahlungsbereich möglichst wenig absorbieren.

Das photopolymerisierbare Gemisch kann für die verschiedensten Anwendungen Einsatz finden, beispielsweise zur Herstellung von Lacken, die durch Licht gehärtet werden, und insbesondere als lichtempfindliches Aufzeichnungsmaterial auf dem Reproduktionsgebiet. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, verwendbar. Besondere Bedeutung haben die erfindungsgemäßen Gemische für die Photoresisttechnik, insbesondere als Trockenphotoresistmaterialien.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen. Ebenso ist es für die Herstellung von Trockenresist geeignet.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckträger, wie Perlongaze, geeignet.

Die Herstellung von strahlungs- bzw. lichtempfindlichen Materialien unter Verwendung des erfindungsgemäßen Gemischs erfolgt in bekannter Weise.

Die Bestandteile werden in einem organischen Lösemittel aufgenommen und die Lösung bzw. Dispersion durch Gießen, Sprühen, Tauchen, Antrag mit Walzen usw. auf den vorgesehenen Träger als Film angetragen und anschließend getrocknet. Die organischen Lösemittel werden je nach der Anwendung ausgewählt. Für die Herstellung von Trockenresists werden im allgemeinen Niedrigsieder, d.h. Lösemittel oder Lösemittelgemische, bei denen mindestens 90 % der Bestandteile unterhalb 100 °C sieden, z. B. Alkohole, Ketone, Ester, Ether und halogenierte Kohlenwasserstoffe, z. B. Methylenchlorid oder Trichlorethan, mit bis zu 4 C-Atomen eingesetzt. Für Sprüh-, Tauch- oder Walzenbeschichtung werden Lösungen in Mittel- bis Hochsiedern, d. h. Lösemitteln mit Siedepunkten von etwa 120 bis 250 °C, z. B. Ethoxypropanol, Methoxybutanol, Butyrolacton, N-Methylpyrrolidon oder Dimethylformamid und Gemischen daraus bevorzugt.

Die Verarbeitung der lichtempfindlichen Materialien wird in bekannter Weise vorgenommen. Die Bebilderung erfolgt durch Belichten mit aktinischer Strahlung. Als aktinische Strahlung soll im Rahmen dieser Beschreibung jede Strahlung verstanden werden, deren Energie mindestens der des kurzwelligen sichtbaren Lichts entspricht. Geeignet ist z. B. langwellige UV-Strahlung, aber auch Laserstrahlung mit einer Wellenlänge >400 nm. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der photopolymerisierbaren Schicht auf dem Träger zurückbleiben.

Die folgenden Beispiele erläutern bevorzugte Ausführungsformen der Erfindung. Mengenverhältnisse und Prozentzahlen sind in Gewichtseinheiten zu verstehen. Die Mengen an Bestandteilen sind in Gewichtsteilen (Gt) angegeben.

In der beiliegenden Formelzeichnung sind Strukturformeln von Piperidinverbindungen angegeben, die in den Beispielen als Stabilisatoren eingesetzt werden.

### Beispiel 1

In loo Gt Butanon wurden
1 Gt Leukokristallviolett und
A 0,05 Gt Verbindung I oder
B 0,05 Gt Verbindung II oder
C 0,05 Gt Verbindung III oder
D 0,05 Gt Di-(1,2,2,6,6-pentamethyl-4-piperidinyl)-butyl-(3′,5′-di-tert.-butyl-4-hydroxybenzyl)-malonate oder
E ohne Zusatz gelöst.

Nach 4 Stunden Stehen wurden die Zu Beginn farblosen Lösungen kolorimetrisch auf ihren Gehalt an Kristallviolett untersucht. Die Lösungen A - D waren hell violett und enthielten etwa 2 ppm Kristallviolett, die Lösung E außerhalb der Erfindung war deutlich dunkler und enthielt 10 ppm Kristallviolett.

### Beispiel 2

In 100 Gt Butanon wurden
1 Gt Leukokristallviolett,
0,1 Gt Tribrommethyl-phenyl-sulfon
und
A 0,1 Gt Verbindung I oder
B 0,1 Gt Verbindung II oder
C 0,1 Gt Verbindung III oder
D kein Zusatz gelöst.

Alle Lösungen waren zunächst farblos. Nach 3 Stunden enthielten die Lösungen A - C etwa 2 ppm und Lösung D (außerhalb der Erfindung) ca. 100 ppm Kristallviolett.

### Beispiel 3

Zu Beschichtungslösungen aus
55 Gt eines Terpolymerisats aus Styrol, n-Hexylmethacrylat und Methacrylsäure (10:60:30) mit der Säurezahl 190,
36 Gt des Umsetzungsprodukts aus 1 mol 2,2,4-Trimethylhexamethylendiisocyanat und 2 mol 2-Hydroxyethylmethacrylat,
39 Gt des Umsetzungsprodukts aus 1 mol n-Butylisocyanat und 1 mol 2-Hydroxy-ethylmethacrylat,
2 Gt Leukokristallviolett,
0,1 Gt Tribrommethyl-phenylsulfon,
0,35 Gt 9-Phenylacridin und
0,035 Gt Waxoline Blue (C.I. 61551) in
30 Gt Ethanol und
150 Gt Butanon
wurde jeweils 0,1 Gt einer der folgenden Substanzen gegeben:
A 2,2,6,6-Tetramethylpiperidin
B 2,2,6,6-Tetramethylpiperidon-(4)
C Verbindung der Formel IV
D Verbindung der Formel V
E Verbindung der Formel III
F Verbindung der Formel I
G 2,2,6,6-Tetramethylpiperidinoxy (freies Radikal; Formel VI)
H t-Butylphenylglycidylether
I Hydrochinonmonomethylether
K 2,4-Dihydroxybenzaldoxim
L Salicylaldoxim
M ohne Zusatz
Nach 40-stündigem Stehen der Lösungen im Dunkeln bei 23 °C wurde ein Teil jeder Lösung auf 25 µm starke Polyethylenterephthalatfolie aufgebracht und 2 Minuten bei 100 °C getrocknet. Man erhielt Trockenresistschichten mit einem Schichtgewicht von 42 g/m², die zum Schutz gegen Verschmutzung mit Polyethylenfolie (20 µm) abgedeckt wurden.

Mit einem Hunter Lab-Farbmeßgerät wurde der Farbort der Schichten gemessen. Die Schichten A - F (L = 77-80) waren hell, die Schichten G - M (L <73) waren dunkel (s. auch Tabelle I).

Weiterhin wurde jeweils ein kleiner Teil jeder Lösung 1:25 mit Butanon verdünnt. Die Lösungen A - F waren blaßblau, die Lösung H violettstichig blau und die Lösungen G und I - M dunkelviolett. Die Lösungen G bis M lagen außerhalb der Erfindung.
Mit einem Perkin-Elmer UV-Spektrometer wurden die Lösungen mit 1 cm-Küvetten gegen eine frische Lösung vermessen. Die Lösungen A - F zeigten keinen Gehalt an Kristallviolett, die Lösung H dagegen einen merklichen Anteil und die Lösungen G und I - M deutlich mehr Kristallviolett.

Die zweite Spalte der Tabelle I gibt die Absorption der Schichten bei 590 nm an, die im wesentlichen durch Kristallviolett verursacht wird.

Die verdünnten Lösungen A - M standen weitere 8 Stunden bei Gelblicht. Während auch danach die Lösungen A - F sehr hell waren, waren die Vergleichslösungen G - M alle dunkel.

**Tabelle I**

| Versuch | L-Wert (Hunter-Lab) | Absorption 590 nm |
|---|---|---|
| A | 79,2 | 0,00 |
| B | 77,9 | 0,01 |
| C | 77,8 | 0,01 |
| D | 79,5 | 0,00 |
| E | 77,8 | 0,01 |
| F | 79,3 | 0,00 |
| G | 64,7 | 0,85 |
| H | 72,6 | 0,12 |
| I | 70,1 | 0,19 |
| K | 69,4 | 0,26 |
| L | 69,1 | 0,27 |
| M | 70,2 | 0,17 |

### Beispiel 4

Beschichtungslösungen aus
50 Gt eines Copolymerisats aus Methylmethacrylat und Methacrylsäure (Säurezahl 115),
50 Gt Trimethylolpropantriacrylat,
1 Gt 9-Phenylacridin,
1 Gt Leukokristallviolett,
1 Gt 2-Methyl-4,6-bis-trichlormethyl-s-triazin und
0,02 Gt 1,4-Bis-(4-tert.butoxy-phenylamino)-5,8-dihydroxyanthrachinon (Polysynthrengrün) in
550 Gt 2-Methoxyethanol und
120 Gt Butanon
wurde zur Stabilisierung
A 1 Gt 2,2,6,6-Tetramethylpiperidin,
B 0,5 Gt 2,2,6,6-Tetramethylpiperidin oder
C nichts zugesetzt

Die Lösungen wurden 64 Stunden verschlossen und im Dunklen bei 22 °C stehen gelassen. Danach war
die Lösung A hellgrün,
die Lösung B hellgrün mit Blaustich und
die Lösung C tiefviolett.

Die Lösungen A - C wurden dann auf elektrolytisch aufgerauhtes und durch Anodisierung gehärtetes 0,3 mm starkes Aluminium durch Aufschleudern aufgetragen. Die Schichten wurden 2 Minuten bei 100 °C getrocknet, wobei man ein Schichtgewicht von 3 g/m² erhielt.

Die Schicht A war sehr hell (L = 51,0), B eine Spur dunkler (L = 46,5) und C sehr dunkel (L = 25,8).

Die lichtempfindlich beschichteten Platten wurden mit einer 15%igen wäßrigen Lösung von Polyvinylalkohol (12 % Restacetylgruppen, K-Wert 4) überzogen und erneut getrocknet, wobei man ein Schichtgewicht von 4 bis 5 g/m² erhielt.

Die so erhaltenen Druckplatten wurden mit einer 5-kW-Metallhalogenidlampe 10 Sekunden in einem Abstand von 80 cm unter einer Negativvorlage zusammen mit einem 13-stufigen Belichtungskeil, der Dichteinkremente von 0,15 enthielt, belichtet. Die Druckplatten A und B zeigten sofort ein Kontrastreiches positives Bild, C außerhalb der Erfidnung dagegen nicht. Die durch Licht nicht gehärteten Teile wurden durch Überwischen mit einer Entwicklerlösung folgender Zusammensetzung entfernt:
3 Gt Natriummetasilikat x 9 H₂O,
0,05 Gt Strontiumchlorid,
0,03 Gt nichtionogenes Netzmittel (Kokosfettalkohol-Polyoxyethylenether mit ca. 8 Oxyethyleneinheiten) und
0,003 Gt Antischaummittel in
100 Gt vollentsalztem Wasser.

Aus der Zahl der voll durchgehärteten Stufen des Belichtungskeils ergab sich, daß die Schicht C (4 Stufen) nur halb so lichtempfindlich war wie die Schichten A und B (beide 6 Stufen).

### Beispiel 5

Lösungen aus
50 Gt eines Terpolymerisats aus Styrol, n-Hexylmethacrylat und Methacrylsäure (10:60:30) mit der Säurezahl 190,
25 Gt des Umsetzungsprodukts aus 1 mol 2,2,6-Trimethylhexamethylendiisocyanat und 2 mol 2-Hydroxyethylmethacrylat,
25 Gt des Umsetzungsprodukts aus 1 mol Hydroxyethylacrylat, 2 mol Caprolacton und 1 mol n-Butylisocyanat,
2,4 Gt Leukomalachitgrün,
0,8 Gt Isopropylthioxanthon,
2,0 Gt p-Dimethylamino-benzoesäureethylester und
0,15 Gt 2-Phenyl-4,6-bis-trichlormethyl-s-triazin in
80 Gt Butanon und
80 Gt Ethanol
wurde:
A 0,1 Gt 2,2,6,6-Tetramethylpiperidin,
B 1 Gt 2,2,6,6-Tetramethylpiperidin,
C 0,05 Gt 2,2,6,6-Tetramethylpiperidin + 0,05 Gt Phenylglycidylether,
D 0,1 Gt 2,2-Di-(3,5-di-tert.-butyl-4-hydroxybenzyl)-malonsäure-di-(1,2,2,6,6-pentamethyl-4-piperidinyl)-ester,
E 0,1 Gt (1,2,2,6,6-Pentamethyl-4-piperidinyl)-acrylat,
F 0,1 Gt Phenylglycidylether,
G 0,1 Gt 2,2,6,6-Tetramethylpiperidinoxy (freies Radikal; Verbindung VI) oder
H nichts zugesetzt.

Nach einem und nach 7 Tagen wurden die Lösungen begutachtet und jeweils ein Teil davon auf Polyesterfolie aufgebracht und getrocknet. Die Lösungen A - E waren auch nach 7 Tagen farblos und hell, die Lösungen F - H waren bereits nach einem Tag grün und stärker noch nach 7 Tagen. Entsprechend waren nach einem und nach 7 Tagen die lichtempfindlichen Folien A - E brilliant hell und die außerhalb der Erfindung liegenden Folien F - H grünlich und unterschiedlich hell. Eine gleichbleibende Qualität an Photoresist läßt sich nur mit Lösungen des Typs A - E herstellen.

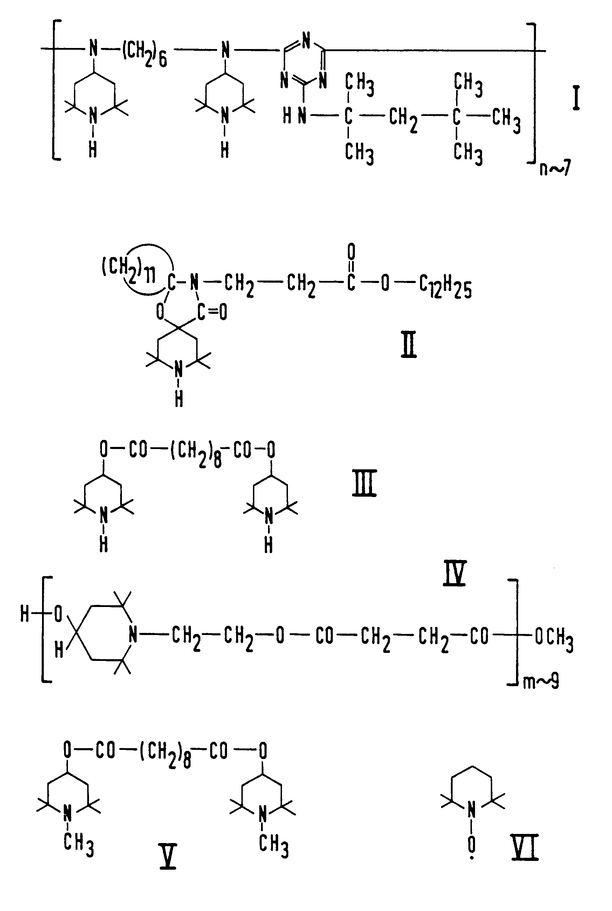

## Patentansprüche

1. Verfahren zum Stabilisieren einer Leukofarbstofflösung in einem organischen Lösemittel gegen Oxydation an der Luft, dadurch gekennzeichnet, daß man der Lösung eine Verbindung zusetzt, die mindestens eine 2,2,6,6-Tetraalkyl-piperidin-, eine 2,2-Dialkyl-piperidin-6-spiro-cycloalkan- oder eine Piperidin-2,6-dispiro-cycloalkangruppierung, ausgenommen das freie 2,2,6,6-Tetramethylpiperidinoxy-Radikal enthält.

2. Verfahren nach Anspruch 1, dadurch gekennzeichnet, daß man eine Piperidinverbindung zusetzt, die am Stickstoffatom ein Wasserstoffatom oder eine ggf. substituierte Alkylgruppe trägt.

3. Verfahren nach Anspruch 1, dadurch gekennzeichnet, daß man eine Verbindung zusetzt, in der der Piperidinring in 4-Stellung an ein Sauerstoff- oder Stickstoffatom eines Substituenten gebunden ist.

4. Verfahren nach Anspruch 1, dadurch gekennzeichnet, daß man eine Verbindung zusetzt, die im Molekül 1 bis 30 substituierte Piperidingruppierungen enthält.

5. Lösung eines Leukofarbstoffs in einem organischen Lösemittel, dadurch gekennzeichnet, daß sie eine Verbindung mit mindestens einer 2,2,6,6-Tetraalkyl-piperidin-, einer 2,2-Dialkyl-piperidin-6-spiro-cycloalkan- oder einer Piperidin-2,6-dispirocycloalkangruppierungn ausgenommen das freie 2,2,6,6-Tetramethylpiperidinoxy-Radikal enthält.

6. Lösung nach Anspruch 5, dadurch gekennzeichnet, daß das organische Lösemittel ein Alkohol, Keton, Ester, Ether oder halogenierter Kohlenwasserstoff ist.

7. Lösung nach Anspruch 5, dadurch gekennzeichnet, daß mindestens 90 % der Lösemittel einen Siedepunkt unterhalb 100 °C haben.

8. Lösung nach Anspruch 5, dadurch gekennzeichnet, daß der Leukofarbstoff ein Triphenylmethan- oder Xanthenfarbstoff ist.

9. Lösung nach Anspruch 5, dadurch gekennzeichnet, daß sie zusätzlich eine strahlungsempfindliche Trihalogenmethylverbindung enthält.

10. Lösung nach Anspruch 5, dadurch gekennzeichnet, daß sie 0,1 bis 150 Gewichtsteile Piperidinverbindung je 100 Gewichtsteile Leukofarbstoff enthält.

11. Durch Strahlung polymerisierbares Gemisch, das als wesentliche Bestandteile eine polymerisierbare Verbindung mit mindestens einer endständigen ethylenischen Doppelbindung und einem Siedepunkt bei Normaldruck oberhalb 100 °C, eine Verbindung, die unter Einwirkung von aktinischer Strahlung die Polymerisation der ungesättigten Verbindung einzuleiten vermag, und einen Leukofarbstoff enthält, dadurch gekennzeichnet, daß es ferner eine Verbindung mit mindestens einer 2,2,6,6-Tetraalkyl-piperidin-, einer 2,2-Dialkyl-piperidin-6-spiro-cycloalkan- oder einer Piperidin-2,6-dispiro-cycloalkan-gruppierung, ausgenommen das freie 2,2,6,6-Tetramethylpiperidinoxy-Radikal enthält.

12. Durch Strahlung polymerisierbares Gemisch nach Anspruch 11, dadurch gekennzeichnet, daß es ferner ein polymeres Bindemittel enthält.

13. Durch Strahlung polymerisierbares Gemisch nach Anspruch 11, dadurch gekennzeichnet, daß es ferner eine Epoxyverbindung als Stabilisator enthält.

## Claims

1. Process for stabilizing a leuco dye solution in an organic solvent against oxidation in the air, characterized in that a compound which contains at least one 2,2,6,6-tetraalkylpiperidine, one 2,2-dialkvlpiperidine-6-spirocycloalkane or one piperidine-2,6-dispirocycloalkane group, with the exception of the free 2,2,6,6-tetramethylpiperidyloxy radical, is added to the solution.

2. Process according to Claim 1, characterized in that a piperidine compound which carries a hydrogen atom or an unsubstituted or substituted alkyl group on the nitrogen atom is added.

3. Process according to Claim 1, characterized in that a compound in which the piperidine ring is bonded in the 4 position to an oxygen or nitrogen atom of a substituent is added.

4. Process according to Claim 1, characterized in that a compound which contains 1 to 30 substituted piperidine groups in the molecule is added.

5. Solution of a leuco dye in an organic solvent, characterized in that it contains a compound having at least one 2,2,6,6-tetraalkylpiperidine, one 2,2-dialkylpiperidine-6-spirocycloalkane or one piperidine-2,6-dispirocycloalkane group, with the exception of the free 2,2,6,6-tetramethylpiperidyloxy radical.

6. Solution according to Claim 5, characterized in that the organic solvent is an alcohol, ketone, ester, ether or halogenated hydrocarbon.

7. Solution according to Claim 5, characterized in that at least 90% of the solvents have a boiling point below 100°C.

8. Solution according to Claim 5, characterized in that the leuco dye is a triphenylmethane or xanthene dye.

9. Solution according to Claim 5 characterized in that it additionally contains a radiation-sensitive trihalomethyl compound.

10. Solution according to Claim 5, characterized in that it contains from 0.1 to 150 parts by weight of piperidine compound per 100 parts by weight of leuco dye.

11. Radiation-polymerizable mixture which contains, as essential components, a polymerizable compound having at least one terminal ethylenic double bond and a boiling point above 100°C at atmospheric pressure, a compound capable of initiating the polymerization of the unsaturated compound under the action of actinic radiation, and a leuco dye, characterized in that it furthermore contains a compound having at least one 2,2,6,6-tetraalkylpiperidine, one 2,2-dialkylpiperidine-6-spirocycloalkane or one piperidine-2,6-dispirocycloalkane group, with the exception of the free 2,2,6,6-tetramethylpiperidyloxy radical.

12. Radiation-polymerizable mixture according to Claim 11, characterized in that it furthermore contains a polymeric binder.

13. Radiation-polymerizable mixture according to Claim 11, characterized in that it furthermore contains an epoxy compound as a stabilizer.

## Revendications

1. Procédé de stabilisation contre l'oxydation à l'air d'une solution de leucodérivé de colorant dans un solvant organique, caractérisé en ce que l'on ajoute à la solution un composé qui contient au moins un groupement 2,2,6,6-tétralkylpipéridine, 2,2-dialkylpipéridine-6-spirocycloalcane ou pipéridine-2,6-dispirocycloalcane, à l'exception du radical libre 2,2,6,6-tétraméthylpipéridinoxy.

2. Procédé selon la revendication 1, caractérisé en ce que l'on ajoute un composé de pipéridine qui porte sur l'atome d'azote un atome d'hydrogène ou un groupe alkyle éventuellement substitué.

3. Procédé selon la revendication 1, caractérisé en ce que l'on ajoute un composé dans lequel le noyau pipéridine est lié en position 4 à un atome d'oxygène ou un atome d'azote d'un substituant.

4. Procédé selon la revendication 1, caractérisé en ce que l'on ajoute un composé qui contient dans la molécule 1 à 30 groupements pipéridiniques substitués.

5. Solution d'un leucodérivé de colorant dans un solvant organique, caractérisée en ce qu'elle contient un composé comprenant au moins un groupement 2,2,6,6-tétralkylpipéridine, 2,2-dialkylpipéridine-6-spirocycloalcane ou pipéridine-2,6-dispirocycloalcane, à l'exception du radical libre 2,2,6,6-tétraméthyl-pipéridinoxy.

6. Solution selon la revendication 5, caractérisée en ce que le solvant organique est un alcool, une cétone, un ester, un éther ou un hydrocarbure halogéné.

7. Solution selon la revendication 5, caractérisée en ce qu'au moins 90 % des solvants ont un point d'ébullition inférieur à 100°C.

8. Solution selon la revendication 5, caractérisée en ce que le leucodérivé de colorant est un colorant de type triphénylméthane ou xanthène.

9. Solution selon la revendication 5, caractérisée en ce qu'elle contient en outre un composé trihalogénométhylé sensible aux rayonnements.

10. Solution selon la revendication 5, caractérisée en ce qu'elle contient 0,1 à 150 parties en masse de composé de pipéridine pour 100 parties en masse de leucodérivé de colorant.

11. Mélange polymérisable par rayonnement, qui contient comme constituants essentiels un composé polymérisable ayant au moins une double liaison éthylénique terminale et un point d'ébullition supérieur à 100°C sous la pression normale, un composé permettant l'amorçage de la polymérisation du composé insaturé sous l'effet d'un rayonnement actinique, et un leucodérivé de colorant, caractérisé en ce qu'il contient en outre un composé comprenant au moins un groupement 2,2,6,6-tétralkylpipéridine, 2,2-dialkylpipéridine-6-spirocycloalcane ou pipéridine-2,6-dispirocycloalcane, à l'exception du radical libre 2,2,6,6-tétraméthylpipéridinoxy.

12. Mélange polymérisable par rayonnement selon la revendication 11, caractérisé en ce qu'il contient en outre un liant polymère.

13. Mélange polymérisable par rayonnement selon la revendication 11, caractérisé en ce qu'il contient en outre un composé époxy comme stabilisant.
